# FASCICULE DE BREVET EUROPEEN

(11) **EP 3 531 444 B1**
(45) Date de publication et mention de la délivrance du brevet: **17.07.2024**
(21) Numéro de dépôt: 19157369.0
(22) Date de dépôt: 15.02.2019
(51) Int. Cl.: H01L 21/762

(54) **CIRCUIT INTÉGRÉ COMPRENANT UN SUBSTRAT ÉQUIPÉ D'UNE RÉGION RICHE EN PIÈGES, ET PROCÉDÉ DE FABRICATION**
INTEGRIERTER SCHALTKREIS, DER EIN SUBSTRAT MIT EINEM BEREICH MIT VIELEN HAFTSTELLEN UMFASST, UND HERSTELLUNGSVERFAHREN
INTEGRATED CIRCUIT INCLUDING A SUBSTRATE PROVIDED WITH A REGION RICH IN TRAPS, AND METHOD FOR MANUFACTURING SAME

(30) Priorité: 23.02.2018 FR 1851615
(43) Date de publication de la demande: 28.08.2019
(73) Titulaire: STMicroelectronics (Crolles 2) SAS, 38920 Crolles (FR)
(72) Inventeur: DUTARTRE, Didier, 38240 MEYLAN (FR)
(74) Mandataire: Casalonga

(56) Documents cités:
- WO-A2-2012/087580
- US-A1- 2016 372 484
- BAINE ET AL: "Cross-talk suppression in SOI substrates", SOLID STATE ELECTRON, ELSEVIER SCIENCE PUBLISHERS, BARKING, GB, vol. 49, no. 9, 1 September 2005 (2005-09-01), pages 1461 - 1465, XP005098756, ISSN: 0038-1101, DOI: 10.1016/J.SSE.2005.07.008

## Description

L'invention concerne le domaine de l'électronique et plus précisément celui des substrats semi-conducteurs permettant la réalisation de circuits électroniques, notamment dédiés à des applications radiofréquence.

En particulier, des modes de mise en oeuvre et de réalisation de l'invention ont trait aux substrats de type silicium sur isolant, également appelée substrat « SOI » en anglais pour « Silicon On Insulator » dédiés à des applications radiofréquence et tout particulièrement les substrats de type silicium totalement déserté sur isolant FD-SOI (d'après l'anglais « Fully Depleted Silicon On Insulator »).

Un substrat de type SOI comprend classiquement un film semi-conducteur (ou couche semi-conductrice supérieure) situé au-dessus d'une couche isolante enterrée (d'oxyde de silicium en général), couramment désignée sous l'acronyme BOX (d'après l'anglais « Burried OXide »), elle-même située au-dessus d'un substrat porteur, par exemple un substrat massif.

Les circuits intégrés radiofréquence (RF) sont généralement de préférence fabriqués sur des substrats semi-conducteurs dopés P de type dit « HR », c'est-à-dire de haute résistivité (typiquement supérieur à 1 kOhm.cm), de manière à limiter les pertes dans le substrat et la diaphonie (« cross-talk ») entre composants voisins, par conduction.

Il est en outre courant de recourir à des substrats HR de type SOI (Silicon On Insulator). Les composants passifs ou actifs formés dans et sur le film semi-conducteur sont alors isolés du substrat porteur par la couche d'oxyde enterrée.

Cependant, il a été observé que recourir à de tels substrats réduit les pertes liées au substrat sans totalement les supprimer. En effet, des charges électriques fixes sont inévitablement présentes dans la couche isolante enterrée (BOX) du fait du procédé de fabrication de cette couche d'oxyde. Elles sont responsables de l'accumulation dans le substrat, au voisinage du BOX, de charges électriques mobiles pouvant former un canal conducteur. Ainsi, bien que l'on ait recours à des substrats de type HR, la conduction parasite de surface dans le substrat est la source de pertes électriques.

L'empilement film semi-conducteur / BOX / Substrat porteur se comporte en outre comme une capacité MOS (Metal Oxide Semiconductor). En première approximation, on considère que l'épaisseur de la couche d'inversion associée à cette capacité MOS évolue inversement avec la racine carrée de la concentration en dopants du substrat porteur. On conçoit donc que cette épaisseur est d'autant plus importante que le substrat porteur est de type HR, c'est-à-dire à faible dopage. Cette capacité présente la caractéristique d'être modulée par le potentiel électrique appliqué aux composants formés dans ou sur le film de silicium isolé, en regard et au-dessus du BOX. Cette capacité parasite modulée est responsable de distorsions harmoniques et de diaphonie affectant les composants RF des circuits intégrés, de manière préjudiciable pour les performances de ces composants. Une telle distorsion peut en particulier être quantifiée par la méthode de détermination du point d'interception du troisième ordre, ou en anglais « Third order intercept point », abrégé en TOIP ou IP3.

Afin de remédier à ce phénomène, il est connu d'utiliser des structures de substrat porteur plus complexes, intégrant une région spécifique séparant la partie monocristalline du substrat porteur et la couche isolante enterrée (BOX) de manière à créer, à proximité de celle-ci, une densité élevée d'états de surface susceptibles de piéger les porteurs libres. Ce piégeage des porteurs libres par les états de surface réduit fortement le phénomène de conduction parasite de surface. Il provoque en outre un ancrage du niveau de Fermi dans le semi-conducteur, à l'interface substrat porteur-BOX (« Fermi level pinning »), ce qui rend la valeur de la capacité MOS parasite largement indépendante du potentiel électrique appliqué aux composants formés en regard, au-dessus de la couche isolante enterrée (BOX), limitant ainsi les distorsions harmoniques. De telles régions spécifiques sont connues par l'homme du métier sous le vocable anglosaxon de régions « trap-rich » (régions riches en pièges). Un tel substrat est qualifié de substrat « trap-rich ».

Les régions « trap-rich » et leur réalisation ont fait l'objet de nombreuses publications, parmi lesquelles on peut citer les documents « BAINE ET AL: "Cross-talk suppression in SOI substrates", SOLID STATE ELECTRON, ELSEVIER SCIENCE PUBLISHERS, BARKING, GB, vol. 49, no. 9, 1 septembre 2005 (2005-09-01), pages 1461-1465 », « SOI technology: An Opportunity for RF Designers, Journal of 30 Télécommunications and Information Technology, 04/2009 » ou encore la demande de brevet internationale PCT/EP2015/056719, ou les demandes de brevets WO 2012/087580 A2, US 2016/372484 A1, qui décrivent une réalisation d'une région riche en pièges de charges « trap-rich » sous la couche isolante enterrée (BOX) d'un substrat SOI.

Cependant, la réalisation d'un circuit intégré dans et sur le film semi-conducteur comporte des étapes de recuit à température élevée, typiquement largement au-delà de 1000°C, notamment pour former des tranchées isolantes peu profondes « STI en anglais pour Shallow Trench Isolation ». Cependant, de tels recuits conduisent à créer une rugosité au niveau de la surface supérieure de la région riche en pièges qui se traduit par une rugosité du film semi-conducteur, ce qui est préjudiciable au bon fonctionnement de certains composants du circuit intégré.

Le placement de la région « trap-rich » sous la couche isolante enterrée dans un substrat de type SOI s'avère d'autant plus problématique que le substrat est de type FD-SOI car l'épaisseur du film semi-conducteur est particulièrement faible, typiquement quelques nanomètres. De même l'épaisseur de la couche isolante enterrée (BOX) est faible, typiquement de l'ordre de 15 à 25nm.

Il existe donc un besoin de proposer, selon un mode de réalisation, un substrat de type SOI, notamment FD-SOI, et dont la présence d'une région riche en pièges (« trap-rich ») ne soit pas préjudiciable à l'état de surface du film semi-conducteur d'un tel substrat.

Selon un aspect, il est proposé un circuit intégré comportant un substrat, au moins un premier domaine, et au moins un deuxième domaine distinct dudit au moins premier domaine, dans lequel le substrat contient une région riche en pièges uniquement dans ledit au moins un deuxième domaine.

Ainsi, contrairement à l'art antérieur, la réalisation d'une région « trap-rich » est localisée seulement à certains endroits du substrat.

Selon un mode de réalisation, ledit au moins un premier domaine contient au moins un composant non radiofréquence et ledit au moins un deuxième domaine contient au moins un composant radiofréquence.

Un composant radiofréquence est un composant susceptible d'être couplé à (par exemple traversé par) au moins un signal radiofréquence lors du fonctionnement du circuit intégré. Un tel composant est par exemple mais non limitativement un composant passif du type inductance, condensateur, résistance, ou encore un guide d'onde.

Un composant non radiofréquence est un composant différent d'un composant radiofréquence, typiquement un composant non destiné à être couplé à un signal radiofréquence, par exemple un transistor appartenant à une partie logique du circuit intégré.

Selon un mode de réalisation, le substrat est du type silicium sur isolant comportant dans ledit au moins un premier domaine, un film semi-conducteur, une première partie d'un substrat porteur et une couche isolante enterrée située entre ladite première partie du substrat porteur et le film semi-conducteur, et comportant dans ledit deuxième domaine une deuxième partie du substrat porteur surmontée de ladite région riche en pièges, le film semi-conducteur et ladite couche isolante enterrée ne s'étendant pas dans ledit au moins un deuxième domaine.

Selon un mode de réalisation, le substrat est de type silicium totalement déserté sur isolant, le film semi-conducteur comportant un matériau semi-conducteur totalement déserté.

La région riche en pièges « trap-rich » est donc présente uniquement dans un domaine comprenant des composants radiofréquence. Cette présence est avantageuse car elle permet de limiter les distorsions harmoniques et la diaphonie affectant les composants radiofréquence dudit domaine du circuit intégré.

Et cette présence n'affecte pas la rugosité de surface du film semi-conducteur d'un substrat de type SOI, en particulier de type FD-SOI, car dans le deuxième domaine (radiofréquence) le film semi-conducteur n'est pas présent. Et la rugosité du film semi-conducteur d'un substrat SOI, en particulier FD-SOI, n'est pas impactée dans le premier domaine (domaine non radiofréquence) par la région riche en pièges qui en est absente, cette absence ne nuisant pas au bon fonctionnement des composants non radiofréquence.

Une région riche en pièges (« trap-rich ») est une région dont la dénomination (« riche en pièges ») et la structure sont bien connues de l'homme du métier compte tenu des nombreuses publications existant sur ce sujet.

Cela étant on peut aussi définir, à titre d'exemple non limitatif, une région riche en pièges comme étant une région qui lorsqu'elle est située sous un composant radiofréquence traversé par un signal radiofréquence, conduit à une atténuation d'au moins 85 dBm de la deuxième harmonique de ce signal.

Selon un mode de réalisation, ladite région riche en pièges comprend au moins un empilement comportant une couche de matériau semi-conducteur polycristallin, et une zone d'interface située entre une partie sous-jacente du substrat et la couche de matériau semi-conducteur polycristallin, ladite zone d'interface présentant une structure distincte de la structure cristalline de ladite couche de matériau semi-conducteur polycristallin, et de la structure cristalline de la partie sous-jacente du substrat.

Selon un mode de réalisation, ladite au moins une couche de matériau semi-conducteur polycristallin présente une épaisseur comprise entre 0.5 et 3 µm.

Selon un mode de réalisation, lorsque le substrat est de type SOI, la partie sous-jacente du substrat est ladite deuxième partie du substrat porteur.

Selon un mode de réalisation, le substrat porteur comprend un substrat de haute résistivité.

Un substrat de haute résistivité est un substrat à faible dopage, et qui présente typiquement une résistivité supérieure à 1 kOhm.cm.

Ce type de substrat est en particulier apprécié pour la réalisation de composants radiofréquence car il limite les pertes dans le substrat et la diaphonie (« cross-talk ») entre composants voisins, par conduction.

Selon un autre aspect, il est également proposé un procédé de réalisation d'un circuit intégré comportant une réalisation d'une région riche en pièges dans seulement une première partie d'un substrat du circuit intégré.

Selon un mode de mise en oeuvre, le procédé comprend une réalisation d'un premier domaine contenant au moins un composant non radiofréquence et une réalisation d'un deuxième domaine contenant au moins un composant radiofréquence ainsi que la région riche en pièges.

Selon un mode de mise en oeuvre, le procédé comprend une réalisation de zones d'isolation dans le substrat, effectuée après la réalisation de ladite région riche en pièges.

Selon un mode de mise en oeuvre, le substrat est de type substrat silicium sur isolant comprenant un film semi-conducteur, un substrat porteur et une couche isolante enterrée située entre le substrat porteur et le film conducteur, et la réalisation de la région riche en pièges comporte :
- une réalisation d'une tranchée dans ledit au moins un deuxième domaine s'étendant jusque dans le substrat porteur ;
- une formation d'au moins une zone d'interface sur la paroi interne de ladite tranchée, ladite zone d'interface ayant une structure cristalline différente du substrat porteur ;
- une formation d'au moins une couche de matériau semi-conducteur polycristallin sur ladite au moins une zone d'interface, la couche de matériau semi-conducteur polycritallin formant ladite région riche en piège, ayant une surface supérieure située sensiblement dans le même plan que la surface supérieure du film semi-conducteur, et présentant une structure distincte de la structure cristalline de la zone d'interface.

Une surface située sensiblement dans le même plan qu'une autre surface s'entend située dans le même plan à une tolérance près, cette tolérance étant liée aux caractéristiques des procédés technologiques mis en oeuvre pour l'obtention de ces surfaces.

Selon un mode de mise en oeuvre, le substrat est de type silicium totalement déserté sur isolant, le film semi-conducteur comportant un matériau semi-conducteur totalement déserté.

Selon un mode de mise en oeuvre, le substrat porteur est un substrat de haute résistivité.

D'autres avantages et caractéristiques de l'invention apparaîtrons à l'examen de la description détaillée de modes mise en oeuvre et de réalisation, nullement limitatifs, et des dessins annexés sur lesquels :

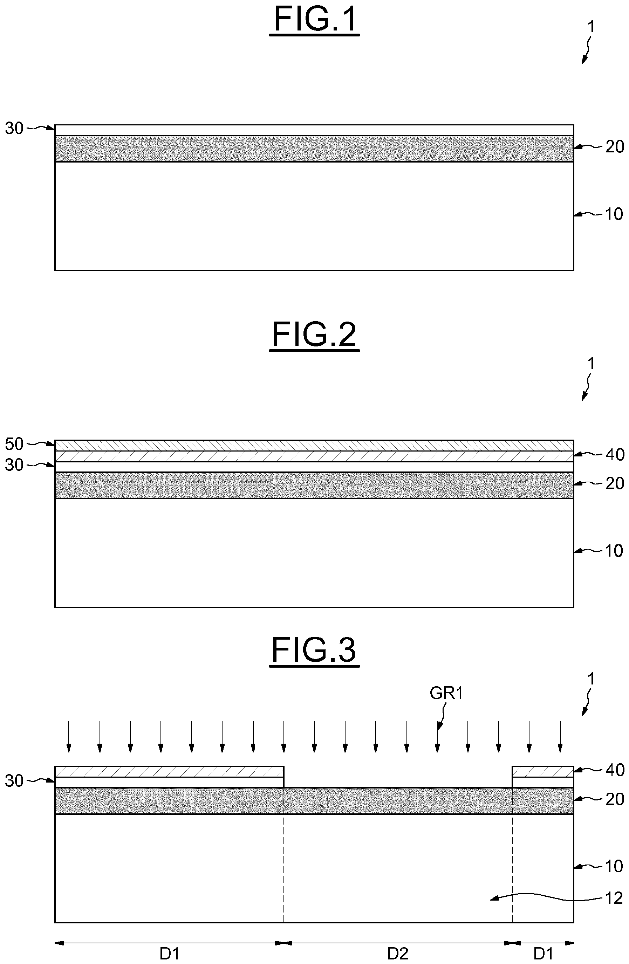

- les figures 1 à 6 illustrent schématiquement un mode de mise en oeuvre d'un procédé selon l'invention et un mode de réalisation d'un circuit intégré selon l'invention.

Bien entendu, pour faciliter la compréhension, les différents éléments représentés aux figures, et en particulier les couches composant le substrat de type silicium sur isolant ont été représentés schématiquement, et les proportions de ces différents éléments peuvent s'écarter des proportions réelles.

La figure 1 représente une vue en coupe d'un substrat de type silicium sur isolant également appelé substrat « SOI » en anglais pour « Silicon On Insulator ».

Le substrat de type SOI comprend classiquement un film semi-conducteur 30 situé au-dessus d'une couche isolante enterrée 20 (d'oxyde de silicium en général), couramment désignée sous l'acronyme BOX (d'après l'anglais Burried OXide), elle-même située au-dessus d'un substrat porteur 10.

Dans cet exemple le substrat est en particulier de type FD-SOI, bien que l'invention puisse s'appliquer à tout type de substrat SOI.

Pour un substrat de type FD-SOI, le matériau formant le film semi-conducteur, typiquement du silicium, est totalement déserté. A cet égard le matériau présente un dopage intrinsèque, typiquement de l'ordre de 10¹⁵ atomes de dopants par cm³. L'épaisseur du film semi-conducteur 30 peut être comprise entre 5 et 6 nm, et l'épaisseur de la couche isolante 20 peut être approximativement de 25 nm.

Le substrat porteur 10 peut être réalisé à partir de tout matériau semi-conducteur, et en particulier à base de silicium monocristallin.

Le substrat porteur est ici avantageusement un substrat semi-conducteur à haute résistivité, c'est-à-dire à relativement faible dopage, et présente typiquement une résistivité supérieure à 1 kOhm.cm. Ce type de substrat est en particulier apprécié pour la réalisation de composants radiofréquence.

Bien sûr, cela n'exclut pas la possibilité d'utiliser un autre type de substrat non à haute résistivité.

Sur la figure 2, une couche 40 dite de « masque dur » (d'après l'anglais « Hard Mask ») est déposée sur la face supérieure du film semi-conducteur 30. Cette couche vise notamment à protéger le film semi-conducteur 30 et va également servir, comme on le verra ci-après, de masque de gravure.

Cette couche 40 peut, par exemple, être en nitrure de silicium, en oxyde-nitrure-oxyde (ONO) ou tout autre matériau approprié.

Une couche de résine 50 de matériau photosensible est déposée sur la face supérieure de la couche 40 de masque dur.
Comme illustré sur la figure 3, le circuit intégré qui va être réalisé dans et sur le substrat 1, comporte plusieurs domaines.

Plus précisément un premier domaine D1 est destiné à recevoir des composants non radiofréquence tandis qu'un deuxième domaine D2 est destiné à recevoir des composants radiofréquence.

Bien entendu, chaque domaine peut être formé d'une seule et même zone ou bien de plusieurs zones disjointes.

Comme illustré sur la figure 3, on procède par une étape classique de photolithographie, insolation et développement de la couche de résine 50 à une délimitation du domaine D2, puis en utilisant le reliquat de résine comme masque de gravure, à une gravure GR1 classique et connue en soi de la couche de masque dur 40.

La surface supérieure de la couche isolante enterrée située au-dessus de la partie 12 du substrat porteur est alors découverte.

La couche de résine 50 est ensuite retirée.

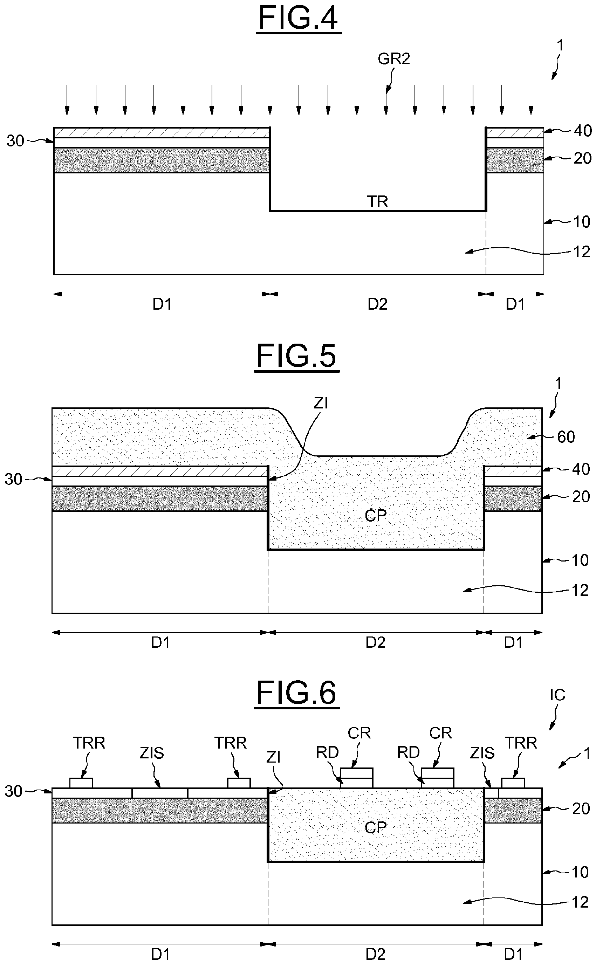

Comme illustré sur la figure 4, on réalise des opérations de gravure GR2 classiques et connues en soi, pour former une tranchée TR s'étendant jusque dans la partie 12 du substrat porteur 10.

La tranchée TR présente une profondeur comprise, par exemple, entre 0.5 et 2 µm.

Cette tranchée TR représente le futur emplacement d'une région riche en pièges connue par l'homme du métier sous le vocable anglosaxon de région « trap-rich ».

Ainsi, cette région riche en pièges sera localisée seulement dans le domaine D2 qui comprendra avantageusement des composants radiofréquence.

Cette présence est avantageuse car elle permet de limiter les distorsions harmoniques et la diaphonie affectant les composants radiofréquence du domaine D2 du substrat 1.

Cette présence n'affecte pas la rugosité de surface du film semi-conducteur 30 du domaine D2 du substrat 1 de type FD-SOI, car dans le domaine D2 (radiofréquence), le film semi-conducteur 30 n'est pas présent.

Par contre, le film semi-conducteur 30 étant présent dans le domaine D1 du substrat 1, sa rugosité n'est pas impactée par la région riche en pièges qui en est absente, cette absence ne nuisant pas au bon fonctionnement des composants non radiofréquence.

Comme illustré sur la figure 5, une couche 60 de matériau semi-conducteur polycristallin est déposée sur la face supérieure de la couche de masque dur 40 et sur la paroi de la tranchée TR, de façon à remplir la tranchée et former une région CP riche en pièges.

Pour éviter une croissance épitaxiale de la couche 60 de matériau semi-conducteur polycristallin sur le substrat porteur monocristallin sous-jacent 12, une formation d'une zone d'interface ZI sur la paroi interne de la tranchée TR est conseillée avant le dépôt de la couche 60 de matériau semi-conducteur polycristallin. Ceci permet la formation de la couche de matériau semi-conducteur polycristallin sans reprise épitaxiale et par conséquent, la formation de pièges conduisant à la formation de la région riche en pièges.

Différentes techniques peuvent être employées pour former la zone d'interface ZI. Il est ainsi possible d'exposer la paroi de la tranchée TR à un environnement comprenant des espèces oxydantes.

Les phénomènes d'oxydation créent dans la paroi interne de la tranchée TR une couche ZI de très faible épaisseur de l'ordre de grandeur du nanomètre, qui présente une structure distincte de la structure cristalline des grains du matériau semi-conducteur polycristallin 60 et du substrat porteur monocristallin sous-jacent 12.

Cette oxydation peut être réalisée par une oxydation thermique contrôlée de type RTO (de l'anglais « Rapid Thermal Oxidation »), c'est-à-dire une oxydation dont la cinétique est augmentée par chauffage de la paroi interne TR, typiquement entre 550°C et 900°C, en présence d'une atmosphère oxydante.

Il est également possible de réaliser cette oxydation en procédant à un traitement oxydant de chimie humide selon des modes opératoires classiques.

Parmi les autres possibilités de réalisation de la zone d'interface ZI, on peut citer des opérations d'implantation ionique d'espèces non-dopantes, telles que l'argon, le germanium ou tout autre ion lourd. Un tel bombardement ionique permet de créer un grand nombre de défauts cristallins ou d'amorphiser, au moins partiellement, la paroi interne de la tranchée TR, c'est-à-dire de rompre l'arrangement cristallin à la surface des grains, ce qui permet d'éviter une croissance épitaxiale lors du dépôt de la couche de matériau semi-conducteur polycristallin 60.

Ainsi, une fois la couche d'interface ZI réalisée, la couche 60 de matériau semi-conducteur polycristallin peut être déposée dans la tranchée TR et sur la couche de masque dur 40.

Le dépôt de la couche de matériau semi-conducteur polycristallin CP peut se faire par une technique de dépôt chimique en phase vapeur, de sorte à former une couche dont l'épaisseur est comprise de préférence entre 500 nanomètres et 2000 nanomètres voire plus, par exemple 3000 nanomètres.

Eventuellement, après son dépôt, la couche de matériau semi-conducteur polycristallin 60 peut subir un traitement thermique adapté à son épaisseur et à sa nature, de sorte à stabiliser sa structure en la recristallisant.

Bien entendu, d'autres techniques de dépôt peuvent être employées pour former cette couche, par exemple des dépôts chimiques en phase vapeur à basse pression (LPCVD), ou plus généralement par tout type de technique de dépôt connue pour permettre la réalisation de couches de matériau semi-conducteur polycristallin.

Plusieurs empilements « couche de matériau semi-conducteur polycristallin - zone d'interface » pourraient être réalisés pour former la région riche en pièges CP.

Par la suite, comme illustré sur la figure 6, la couche de matériau semi-conducteur polycristallin 60 est aplanie, par exemple par polissage mécanochimique (CMP pour « Chemical Mechanical Planarization »). La couche de masque dur 40 est également retirée.

Les étapes de formation du circuit intégré s'effectuent en fait sur la totalité d'une plaquette semiconductrice (wafer). Ce sont des opérations dites « pleine plaque »

Aussi, est-il possible, avant d'effectuer la planarisation de la couche de matériau semi-conducteur polycristallin 60 par polissage mécanochimique, de réaliser une gravure partielle de la couche 60 dans le domaine D1 dans le but de retirer la couche de matériau semi-conducteur polycristallin 60 présente dans ce domaine.

Cette méthode permet d'éviter d'effectuer ultérieurement une planarisation pleine plaque sur une très grande surface ce qui peut provoquer des cuvettes par endroits.

Après retrait de la couche de masque dur 40, il peut subsister une marche entre la partie supérieure du film semi-conducteur 30 et la partie supérieure de la région riche en pièges CP. Il est possible de laisser la marche telle quelle ou d'effectuer un retrait localisé de la marche, correspondant de préférence à l'épaisseur de la couche de masque dur 40.

Puis, comme illustré sur la figure 6, on procède à la réalisation de régions isolantes ZIS, par exemple des tranchées d'isolation peu profondes, ou un oxyde local (LOCOS pour « LOCal Oxydation of Silicon » selon le terme usuel anglosaxon), dans le film semi-conducteur 30.

Puis, on procède à la formation de façon classique de composants non radiofréquence TRR par exemple, des transistors dans le domaine D1, et également à la formation de façon classique de composants radiofréquence CP, par exemple, des inductances dans le domaine D2. Ces composants radiofréquences sont en pratique séparés de la région riche en pièges par une région diélectrique RD, généralement épaisse. Lorsque ces composants sont par exemple réalisés au premier niveau de métallisation du circuit intégré, la région RD est la région connue par l'homme du métier sous le vocable « région PMD » (PMD : « PreMetal Dielectric »).

Ensuite, on termine la fabrication du circuit intégré IC par des étapes habituelles classiques non représentées ici à des fins de simplification.

Comme illustré dans la figure 6, le circuit intégré IC comprend ici le substrat 10 de type FD-SOI, le premier domaine D1 et le deuxième domaine D2. Le substrat contient une région riche en pièges uniquement dans le deuxième domaine D2.

Le premier domaine D1 comporte un film semi-conducteur 30 sur lequel sont présents des composants non radiofréquence TRR .

Le deuxième domaine D2 comporte, outre la région riche en pièges CP, des composants radiofréquence CR formés sur la face supérieure de ladite région riche en pièges CP. La région riche en pièges CP est séparée de la deuxième partie 12 du substrat porteur 12 par la zone d'interface ZI.

L'invention n'est pas limitée à ces modes de mise en oeuvre mais en embrasse toutes les variantes. Par exemple, bien qu'on ait décrit un substrat SOI, l'invention peut s'appliquer à un substrat massif comprenant une région riche en pièges localisée seulement à certains endroits.

## Revendications

1. Circuit intégré (IC) comportant un substrat (1), au moins un premier domaine (D1), et au moins un deuxième domaine (D2) distinct dudit au moins un premier domaine (D1), dans lequel le substrat (1) est du type silicium sur isolant comportant dans ledit au moins un premier domaine (D1), un film semi-conducteur (30), une première partie d'un substrat porteur et une couche isolante (20) enterrée située entre ladite première partie du substrat porteur et le film semi-conducteur (30), et dans lequel le substrat contient une région riche en pièges (CP) uniquement dans ledit au moins un deuxième domaine (D2) et comporte dans ledit au moins un deuxième domaine (D2) une deuxième partie du substrat porteur (12) surmontée de ladite région riche en pièges (CP), le film semi-conducteur (30) et ladite couche isolante (20) enterrée ne s'étendant pas dans ledit au moins un deuxième domaine (D2).

2. Circuit intégré (IC) selon la revendication 1, dans lequel ledit au moins un premier domaine (D1) contient au moins un composant non radiofréquence (TRR) et ledit au moins un deuxième domaine (D2) contient au moins un composant radiofréquence (CR).

3. Circuit intégré (IC) selon la revendication 1 ou 2, dans lequel le substrat est de type silicium totalement déserté sur isolant, le film semi-conducteur (30) comportant un matériau semi-conducteur totalement déserté.

4. Circuit intégré (IC) selon l'une des revendications 1 à 3, dans lequel ladite région riche en piège (CP) comprend au moins un empilement comportant une couche de matériau semi-conducteur polycristallin (60), et une zone d'interface (ZI) située entre une partie sous-jacente du substrat et la couche de matériau semi-conducteur polycristallin (60), ladite zone d'interface (ZI) présentant une structure distincte de la structure cristalline de ladite couche de matériau semi-conducteur polycristallin (60), et de la structure cristalline de la partie sous-jacente du substrat.

5. Circuit intégré (IC) selon la revendication 4, dans lequel ladite au moins une couche de matériau semi-conducteur polycristallin (60) présente une épaisseur comprise entre 0.5 et 3 µm.

6. Circuit intégré (IC) selon la revendication 4 ou 5, dans lequel la partie sous-jacente du substrat est ladite deuxième partie (12) du substrat porteur (10).

7. Circuit intégré (IC) selon l'une des revendications précédentes, dans lequel le substrat porteur (10) comprend un substrat de haute résistivité.

8. Procédé de réalisation d'un circuit intégré (IC) comportant une réalisation d'une région riche en pièges (CP) dans seulement une partie d'un substrat du circuit intégré, le substrat étant du type substrat silicium sur isolant comportant un film semi-conducteur (30), un substrat porteur (10) et une couche isolante (20) enterrée située entre le substrat porteur (10) et le film conducteur (30), et dans lequel la réalisation de la région riche en pièges (CP) comporte:
- une réalisation d'un premier domaine (D1) et d'au moins un deuxième domaine (D2),
- une réalisation d'une tranchée (TR) dans ledit au moins un deuxième domaine (D2) s'étendant jusque dans le substrat porteur (10);
- une formation d'au moins une zone d'interface (ZI) sur la paroi interne de ladite tranchée (TR), ladite zone d'interface (ZI) ayant structure cristalline différente du substrat porteur (10) ;
- une formation d'au moins une couche de matériau semi-conducteur polycristallin (60) sur ladite au moins une zone d'interface (ZI), la couche de matériau semi-conducteur polycristallin (60) formant ladite région riche en piège (CP), ayant une surface supérieure située sensiblement dans le même plan que la surface supérieure du film semi-conducteur (30), et présentant une structure distincte de la structure cristalline de la zone d'interface (ZI).

9. Procédé selon la revendication 8, comprenant une réalisation d'un premier domaine (D1) contenant au moins un composant non radiofréquence (TRR) et une réalisation d'un deuxième domaine (D2) contenant au moins un composant radiofréquence (CR) ainsi que la région riche en pièges (CP).

10. Procédé selon la revendication 8 ou 9, comprenant une réalisation de zones d'isolation (ZIS) dans le substrat, effectuée après la réalisation de la région riche en pièges (CP).

11. Procédé selon l'une des revendications 8 à 10, dans lequel le substrat est de type silicium totalement déserté sur isolant, le film semi-conducteur (30) comportant un matériau semi-conducteur totalement déserté.

12. Procédé selon l'une des revendications 8 à 11, dans lequel le substrat porteur (10) comporte un substrat de haute résistivité.

## Patentansprüche

1. Integrierte Schaltung (IC), die ein Substrat (1), mindestens ein erstes Gebiet (D1) und mindestens ein zweites Gebiet (D2), das sich von dem mindestens einen ersten Gebiet (D1) unterscheidet, umfasst, wobei das Substrat (1) vom Typ Silizium-auf-Isolator ist, der in dem mindestens einen ersten Gebiet (D1) einen Halbleiterfilm (30), einen ersten Abschnitt eines Trägersubstrats und eine Isolierschicht (20), die zwischen dem ersten Abschnitt des Trägersubstrats und dem Halbleiterfilm (30) vergraben ist, umfasst, und wobei das Substrat einen Trap-Rich-Bereich (CP) nur in dem mindestens einen zweiten Gebiet (D2) enthält und einen zweiten Abschnitt des Trägersubstrats (12) in dem mindestens einen zweiten Gebiet (D2) enthält, das von dem Trap-Rich-Bereich (CP) überragt wird, wobei sich der Halbleiterfilm (30) und die vergrabene Isolierschicht (20) nicht in das mindestens eine zweite Gebiet (D2) hinein erstrecken.

2. Integrierte Schaltung (IC) nach Anspruch 1, wobei das mindestens eine erste Gebiet (D1) mindestens eine Nicht-Hochfrequenzkomponente (TRR) enthält und das mindestens eine zweite Gebiet (D2) mindestens eine Hochfrequenzkomponente (CR) enthält.

3. Integrierte Schaltung (IC) nach Anspruch 1 oder 2, wobei das Substrat vom Typ vollständig verarmtes Silizium-auf-Isolator ist und der Halbleiterfilm (30) ein vollständig verarmtes Halbleitermaterial umfasst.

4. Integrierte Schaltung (IC) nach einem der Ansprüche 1 bis 3, wobei der Trap-Rich-Bereich (CP) mindestens einen Stapel umfasst, der eine polykristalline Halbleitermaterialschicht (60) und eine Grenzflächenzone (ZI) umfasst, die sich zwischen einem darunter liegenden Abschnitt des Substrats und der polykristallinen Halbleitermaterialschicht (60) befindet, wobei die Grenzflächenzone (ZI) eine Struktur aufweist, die sich von der kristallinen Struktur der polykristallinen Halbleitermaterialschicht (60) und der kristallinen Struktur des darunter liegenden Abschnitts des Substrats unterscheidet.

5. Integrierte Schaltung (IC) nach Anspruch 4, wobei die mindestens eine polykristalline Halbleitermaterialschicht (60) eine Dicke zwischen 0,5 und 3 µm aufweist.

6. Integrierte Schaltung (IC) nach Anspruch 4 oder 5, wobei der darunter liegende Abschnitt des Substrats der zweite Abschnitt (12) des Trägersubstrats (10) ist.

7. Integrierte Schaltung (IC) nach einem der vorhergehenden Ansprüche, wobei das Trägersubstrat (10) ein Substrat mit hohem Widerstand umfasst.

8. Verfahren zum Herstellen einer integrierten Schaltung (IC), das das Herstellen eines Trap-Rich-Bereichs (CP) nur in einem ersten Abschnitt eines Substrats der integrierten Schaltung umfasst, wobei das Substrat vom Typ Silizium-auf-Isolator ist, der einen Halbleiterfilm (30), ein Trägersubstrat (10) und eine Isolierschicht (20), die zwischen dem Trägersubstrat (10) und dem Halbleiterfilm (30) vergraben ist, umfasst, und wobei das Herstellen des Trap-Rich-Bereichs (CP) Folgendes umfasst:
- Herstellen eines ersten Gebiets (D1) und mindestens eines zweiten Gebiets (D2),
- Herstellen eines Grabens (TR), in dem sich das mindestens eine zweite Gebiet (D2) bis zum Trägersubstrat (10) erstreckt;
- Bilden mindestens einer Grenzflächenzone (ZI) auf der Innenwand des Grabens (TR), wobei die Grenzflächenzone (ZI) eine andere kristalline Struktur als das Trägersubstrat (10) aufweist;
- Bilden mindestens einer polykristallinen Halbleitermaterialschicht (60) in der mindestens einen Grenzflächenzone (ZI), wobei die polykristalline Halbleitermaterialschicht (60) den Trap-Rich-Bereich (CP) bildet, der eine obere Oberfläche aufweist, die sich im Wesentlichen in der gleichen Ebene wie die obere Oberfläche des Halbleiterfilms (30) befindet und eine Struktur aufweist, die sich von der kristallinen Struktur der Grenzflächenzone (ZI) unterscheidet.

9. Verfahren nach Anspruch 8, das das Herstellen eines ersten Gebiets (D1), das mindestens eine Nicht-Hochfrequenzkomponente (TRR) enthält, und das Herstellen eines zweiten Gebiets (D2) umfasst, das mindestens eine Hochfrequenzkomponente (CR) sowie den Trip-Rich-Bereich (CP) enthält.

10. Verfahren nach Anspruch 8 oder 9, das das Herstellen von Isolierzonen (ZIS) im Substrat umfasst, das nach dem Herstellen des Trip-Rich-Bereichs (CP) ausgeführt wird.

11. Verfahren nach einem der Ansprüche 8 bis 10, wobei das Substrat vom Typ vollständig verarmtes Silizium-auf-Isolator ist und der Halbleiterfilm (30) ein vollständig verarmtes Halbleitermaterial umfasst.

12. Verfahren nach einem der Ansprüche 8 bis 11, wobei das Trägersubstrat (10) ein Substrat mit hohem Widerstand umfasst.

## Claims

1. An integrated circuit (IC) including a substrate (1), at least one first domain (Dl), and at least one second domain (D2) distinct from said at least one first domain (Dl), wherein the substrate (1) is of the silicon-on-insulator type including in said at least one first domain (Dl), a semiconductor film (30), a first part of a carrier substrate and an insulating layer (20) buried between said first part of the carrier substrate and the semiconductor film (30), and wherein the substrate contains a trap-rich region (CP) only in said at least one second domain (D2) and includes in said at least one second domain (D2) a second part of the carrier substrate (12) surmounted by said trap-rich region (CP), the semiconductor film (30) and said buried insulating layer (20) not extending into said at least one second domain (D2).

2. The integrated circuit (IC) according to claim 1, wherein said at least one first domain (Dl) contains at least one non-radio frequency component (TRR) and said at least one second domain (D2) contains at least one radio frequency component (CR).

3. The integrated circuit (IC) according to claim 1 or 2, wherein the substrate is of the fully depleted silicon on insulator type, the semiconductor film (30) including a fully depleted semiconductor material.

4. The integrated circuit (IC) according to one of claims 1 to 3, wherein said trap-rich region (CP) comprises at least one stack including a layer of polycrystalline semiconductor material (60), and an interface area (ZI) located between an underlying part of the substrate and the layer of polycrystalline semiconductor material (60), said interface area (ZI) having a structure distinct from the crystalline structure of said layer of polycrystalline semiconductor material (60), and the crystal structure of the underlying part of the substrate.

5. The integrated circuit (IC) according to claim 4, wherein said at least one layer of polycrystalline semiconductor material (60) has a thickness comprised between 0.5 and 3 µm.

6. The integrated circuit (IC) according to claim 4 or 5, wherein the underlying part of the substrate is said second part (12) of the carrier substrate (10).

7. The integrated circuit (IC) according to one of the preceding claims, wherein the carrier substrate (10) comprises a high resistivity substrate.

8. A method for producing an integrated circuit (IC) including producing a trap-rich region (CP) in only part of a substrate of the integrated circuit, the substrate being of the silicon-on-insulator substrate type including a semiconductor film (30), a carrier substrate (10) and a buried insulating layer (20) located between the carrier substrate (10) and the conductive film (30), and wherein the creation of the trap-rich region (CP) includes:
- producing a first domain (Dl) and at least one second domain (D2),
- producing a trench (TR) in said at least one second domain (D2) extending into the carrier substrate (10);
- forming at least one interface area (ZI) on the internal wall of said trench (TR), said interface area (ZI) having a crystalline structure different from the carrier substrate (10);
- forming at least one layer of polycrystalline semiconductor material (60) on said at least one interface area (ZI), the layer of polycrystalline semiconductor material (60) forming said trap-rich region (CP), having an upper surface located substantially in the same plane as the upper surface of the semiconductor film (30), and having a structure distinct from the crystal structure of the interface area (ZI).

9. The method according to claim 8, comprising a production of a first domain (Dl) containing at least one non-radiofrequency component (TRR) and a production of a second domain (D2) containing at least one radiofrequency component (CR) as well as the trap-rich region (CP).

10. The method according to claim 8 or 9, comprising producing isolation areas (ZIS) in the substrate, carried out after producing the trap-rich region (CP).

11. The method according to one of claims 8 to 10, wherein the substrate is of the fully depleted silicon on insulator type, the semiconductor film (30) including a fully depleted semiconductor material.

12. The method according to one of claims 8 to 11, wherein the carrier substrate (10) includes a high resistivity substrate.
